**Europäisches Patentamt**

(19) **European Patent Office**     (11) Numéro de publication: **0 018 924**

**Office européen des brevets**                  **B2**

# (12) NOUVEAU FASCICULE DE BREVET EUROPÉEN

(45) Date de publication du nouveau fascicule du brevet: 04.01.89

(51) Int. Cl.⁴: **H 01 L 25/04,** H 01 L 31/06

(21) Numéro de dépôt: **80400619.5**

(22) Date de dépôt: **07.05.80**

(54) Procédé de fabrication de panneaux de photopiles solaires et panneaux obtenus par ce procédé.

(30) Priorité: **06.05.79 FR 7911631**
**25.03.80 FR 8006568**

(43) Date de publication de la demande:
**12.11.80 Bulletin 80/23**

(45) Mention de la délivrance du brevet:
**25.01.84 Bulletin 84/4**

(45) Mention de la decision concernant l'opposition:
**04.01.89 Bulletin 89/1**

(84) Etats contractants désignés:
**AT BE CH DE GB IT LI LU NL**

(56) Documents cité:
**DE-A-2 443 699**
**DE-A-2 826 789**
**DE-C-2 333 186**
**FR-A-2 349 959**
**GB-A-2 000 371**
**JP-A-51 062 691**
**US-A-3 344 014**
**US-A-3 653 970**
**US-A-4 057 439**
**US-A-4 067 764**
**US-A-4 083 097**

(73) Titulaire: **SAINT- GOBAIN VITRAGE, Les Miroirs 18, avenue d'Alsace, F-92400 Courbevoie (FR)**

(72) Inventeur: **Dran, Maurice, 11, rue de l'Armorique, F-75015 Paris (FR)**
Inventeur: **Dages, Daniel, 1, rue des Closeaux, F-78130 Les Mureaux (FR)**
Inventeur: **Le Gravier, Serge, 12 Venelle Gambetta, F-45000 Orleans (FR)**

(74) Mandataire: **Eudes, Marcel, Saint- Gobain Recherche 39 Quai Lucien Lefranc, F-93304 Aubervilliers Cedex (FR)**

EP 0 018 924 B2

## Description

La présente invention concerne un procedé de fabrication d'un panneau de photopiles solaires formant une batterie électrique, comprenant la formation d'un assemblage par insertion entre deux feuilles rigides externes d'une pluralité de photopiles électriquement raccordées entre elles et aboutissant à des connexions électriques de sortie dans un élément intercalaire central comportant des évidements dans lesquels peuvent se loger ladite batterie de photopiles et ses raccordements électriques et constitué d'au moins une matière thermoplastique, au moins celle desdites feuilles rigides qui est disposée du côté de la face de réception des photopiles étant transparente, ledit procédé comprenant en outre l'application d'un vide à l'espace compris entre lesdites feuilles rigides et un échauffement de l'assemblage à température suffisante pour ramollir ladite matière plastique et l'amener a coller auxdites feuilles rigides et à enfermer lesdites photopiles et connexions, tout en provoquant l'élimination de l'air occlus. Un tel procédé est décrit dans le document FR-A-2 349 959.

Les photopiles solaires ont comme application principale la fourniture d'énergie électrique à des dispositifs tels que des bases lumineuses, des bases radio-électriques, terrestres ou maritimes, des réémetteurs de télévision en milieu montagneux, etc...

En général, les photopiles solaires électriquement interconnectées sont disposées en batteries se présentant sous forme de panneaux faciles à monter et à utiliser. Il est très important qu'un panneau conserve ses qualités dans le temps, ce qui impose que la surface de la photopile, tels que les semi-conducteurs à silicium, reste stable, et pour cela, que les photopiles soient protégées vis-à-vis de l'atmosphère. Il est donc nécessaire que le panneau reste étanche vis-à-vis notamment de l'air et de l'humidité sous peine de voir tomber le rendement des photopiles, car en pratique, la durée de vie de celles-ci est celle de leur encapsulation.

D'autre part, pour disposer d'une puissance électrique intéressante, les panneaux solaires doivent avoir des dimensions suffisantes. Or, le coût des panneaux est élevé et dépend de la valeur du semi-conducteur utilisé, de celle des supports mécaniques, du temps de manipulation consacré à la fabrication du panneau, compte tenu du soin que l'on doit y apporter.

Quelques types de panneaux solaires ont déjà fait leur apparition sur le marché. Il se révèle très difficile de réaliser un panneau exempt de bulles ou autres défauts en utilisant seulement deux feuilles thermoplastiques, de polyvinylbutyral, résine la plus largement utilisée pour la constitution de vitrages feuilletés. Même lorsque l'on insère les photopiles dans des évidements pratiqués dans un élément central en un matériau thermoplastique en forme de film, disposé entre les deux feuilles thermoplastiques (selon par exemple FR 2 349 959), les panneaux solaires résultants peuvent présenter, après thermocollage, des bris de photopiles ou des contraintes sur celles-ci telles que, lorsque les panneaux sont soumis à l'alternance répétée des températures élevées de la période diurne et des basses températures de la période nocturne, ils montrent des décollements et des ruptures du matériau fragile qui constitue la photopile. Ces phénomènes sont d'autant plus accentués que les cellules photovoltaïques sont plus minces, présentent plus de défauts de planéité et plus de surépaisseurs, liées à la présence de grilles collectrices étamées aux soudures des interconnexions. En effet la feuille thermoplastique, notamment celle de butyral de polyvinyle, est un matériau assez dur, résistant au poinçonnement qui, au moment du thermocollage, ne se ramollit que superficiellement et ne peut, de ce fait, absorber suffisamment les variations locales d'épaisseur du matériau à enrober. C'est pourquoi certains panneaux solaires sont réalisés en disposant une batterie de photopiles interconnectées entre deux lames de verre, l'interstice entre les lames et les photopiles étant rempli d'une résine transparente sous forme de sirop qui se fige ultérieurement, par exemple par polymérisation. Les panneaux préparés par cette technique peuvent présenter des défauts d'homogénéité ou des bulles qui s'introduisent au moment de l'injection de la résine. Dans ce cas, de tels panneaux sont considérés comme inutilisables. Cette technique de fabrication demande beaucoup de soins et de temps, et par conséquent elle augmente le coût du watt solaire installé.

La présente invention concerne un procédé de fabrication d'un panneau de photopiles solaires du type mentionné au début du présent mémoire, ledit procédé consistant pour préparer ledit élément intercalaire, à remplir d'un mélange d'une poudre de résine thermoplastique et d'un plastifiant un moule préformeur, le fond dudit moule présentant, pour produire lesdits évidents, des bossages reliefs destinés à y reproduire l'empreinte du réseau des photopiles, à aplanir la surface supérieure de la poudre, à chauffer le moule ainsi rempli à la température de frittage de la resine, à démouler ledit élément intercalaire fritté, la préparation de l'assemblage comportant ensuite la mise en place dudit élément sur l'une des feuilles rigides avec les évidements ouverts vers le haut, l'introduction du réseau des photopiles interconnectées dans les évidements et le dépôt la seconde des feuilles rigides l'échauffement subséquent, combiné à l'application d'une vide, étant conduit jusqu'à un niveau de température provoquant la fusion in situ de la résine particulaire plastifiée.

On obtient ainsi un panneau exempt de bulles et de toute autre hétérogénéité, notamment de contraintes mécaniques ou de cellules brisées. L'étanchéité du panneau peut être assurée par une bande de garde suffisamment large de résine thermoplastique ou bien par l'utilisation d'un joint périphérique surmoulé en un autre matériau. Bien entendu, on utilisera une résine thermoplastique qui devient transparente après la fusion.

De plus l'utiliasation d'une préforme frittée permet d'opérer avec une meilleure précision et notamment d'éviter les variations aléatoires d'épaisseur de la couche de poudre de résine thermoplastique qui peuvent se produire au moment du remplissage, variations qui peuvent entraîner le décollement ou la rupture des feuilles rigides ou la détérioration du réseau.

L'avantage de ce procédé réside dans le fait que le frittage, qui ne modifie pas l'épaisseur de la préforme, conduit à des portées régulières.

L'invention sera à présent décrite en détail à l'aide des dessins annexés dans lesquels:

la fig. 1 est une vue de dessus du panneau de photopiles obtenu par le procédé selon l'invention;

la fig. 2 est une coupe schématique et à plus grande échelle suivant la ligne II - II de la fig. 1;

la fig. 3 est une variante de panneau réalisé selon l'invention;

la fig. 4 illustre une phase de la réalisation du panneau, et

la fig. 5 représente en coupe longitudinale l'installation de fabrication de la préforme.

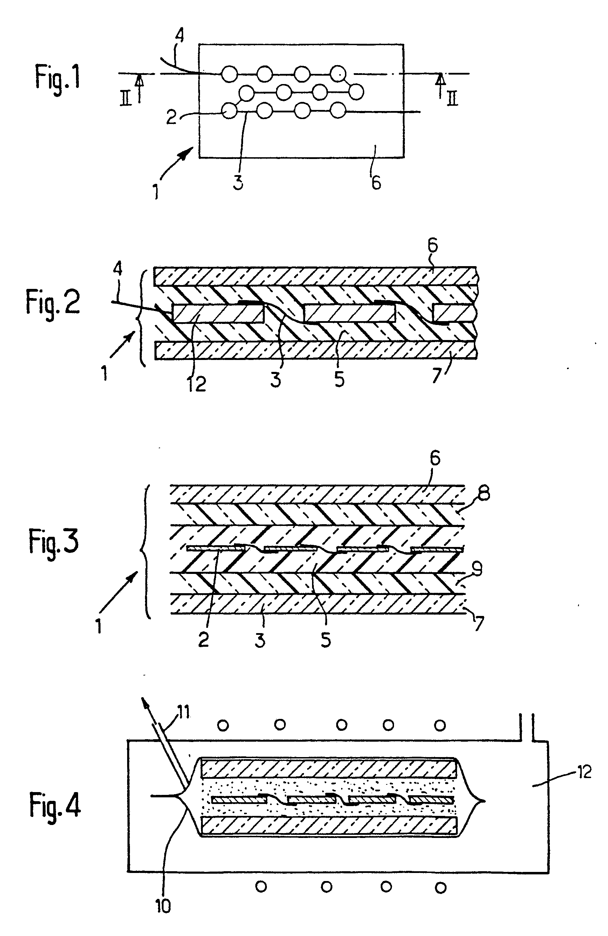

Les figs 1 et 2 montrent un panneau 1 à l'état terminé. Ce panneau est constitué de photopiles solaires élémentaires 2 interconnectées électriquement par des languettes conductrices 3 et comportant au moins deux connexions telles que 4 pour la liaison avec l'extérieur.

Conformément au procédé qui sera décrit par la suite, les photopiles 2 se trouvent noyées dans une couche 5 de matière thermoplastque transparente. Cette couche est placée entre deux feuilles rigides étanches 6 et 7 dont au moins l'une, la feuille 6, est réalisée en une matière transparente, par exemple en verre, ou en une matière plastique ou vitrocristalline transparente. Avantageusement, les deux feuilles rigides sont en verre.

Une variante de réalisation de panneau est représentée par la fig. 3. Cette variante consiste à enfermer la couche 5 entre deux feuilles thermoplastiques souples 8 et 9 soudables respectivement à la matière constitutive de la couche 5 et aux feuilles rigides. Les feuilles 8 et 9 peuvent être réalisées avantageusement avec le même matériau que la couche 5.

Avantageusement, on choisit comme matière thermoplastique pour la couche 5 une résine synthétique comme le polyvinylbutyral plastifié. Une telle résine est décrite dans la publication de brevet français 2 401 941.

Généralement, les plastifiants utilisés sont des esters insolubles dans l'eau, d'acides à plusieurs groupements carboxyliques ou bien d'alcools à plusieurs groupements hydroxyliques. Les plastifiants que l'on peut utiliser sont, par exemple, les dérivés des polyéthylèneglycols comme le di-(éthyl-2-butyrate) de triéthylèneglycol, le dipélargonate de triéthylèneglycol, des adipates comme l'adipate de dihexyle, le dibutoxyéthyladipate, les adipates d'alkyle et d'aryle tels qu'indiqués dans la demande de brevet français no 7 832 737 déposée le 21 novembre 1978 au nom de la demanderesse, le dibutyl sébaçate...

L'énumération ci-dessus des plastifiants utilisables avec la résine de polyvinylbutyral n'est pas limitative. L'homme de l'art saura sélectionner le plastifiant le plus convenable parmi tous les produits connus.

Les cellules solaires peuvent être en silicium monocristallin ou polycristallin, en tellurure de cadmium, en sulfure de cadmium, en arséniure de gallium poly ou mono cristallin, en phosphure d'indium, etc. Les languettes de connexion et de sortie sont par exemple en cuivre étamé, en argent, en aluminium, en leurs alliages ou en tout autre composé métallique présentant une bonne conductivité électrique. Des panneaux étanches ont été réalisés par la demanderesse en utilisant deux feuilles de verre de 3 mm d'épaisseur, de la résine polyvinylbutyral telle que décrite dans la publication FR-A-2 401 941 déjà citée, un plastifiant, des photopiles de silicium sous forme de disques de 0,3 mm d'épaisseur et de 57 mm de diamètre. Les connexions sont en cuivre étamé.

Des procédés de fabrication des panneaux de photopiles seront à présent décrits à propos des exemples suivants:

**Exemplel 1**

Sur une feuille de verre maintenue horizontale, on distribue au travers d'un tamis une couche uniforme d'un mélange de poudres de résine de polyvinylbutyral et de plastifiant constitué par du di-(éthyl-2-butyrate) de triéthylèneglycol à raison de 41 parties en poids de plastifiant pour 100 parties en poids de résine. Ce mélange a été préparé préalablement dans un mélangeur planétaire, du genre pétrin, à température ambiante.

La masse volumique apparente du mélange est de 0,2 g/cm$^3$. L'épaisseur de la couche de résine plastifiée déposées sur la feuille de verre est de 5 mm. Les cellules interconnectées du panneau sont disposées sur la couche de poudre plastifiée à l'aide d'un système de prélèvement pneumatique comportant une ventouse pour chaque cellule.

Une nouvelle couche de résine plastifiée identique à la précédente est ensuite distribuée sur le stratifié précédent. La couche est aussi uniforme que possible et d'épaisseur 5 mm. Une plaque de verre de 3 mm est posée au-dessus de la dernière couche.

Le sandwich ans obtenu est alors glissé dans un sac souple 10, par exemple en caoutchouc, dans lequel un vide peut être réalisé à l'aide d'une tubulure 11 reliée à une pompe à vide non représentée, afin d'éliminer les gaz occlus. Le sac est placé dans un autoclave 12. Le vide est réalisé dans le sac à température ambiante pendant une demi-heure environ, puis une surpression de 2 bars est appliquée à l'extérieur du sac en admettant de l'air comprimé dans l'autoclave. Le vide est toujours maintenu à interieur du sac. On commence alors à augmenter progressivement la température dans l'autoclave à raison d'environ 4°C/minute. Lorsque la température atteint 100°C, la surpression appliquée à l'extérieur du sac est portée en 5 minutes à 10 bars. La température est amenée ensuite à 140°C. L'ensemble est maintenu sous 10 bars et 140°C pendant 30 minutes, temps au bout duquel on refroidit progressivement l'ensemble sous pression. On décomprime l'autoclave, on casse le vide et on récupère le panneau. Le panneau de photopiles solaires ne présente, par transparence, ni bulles ni hétérogénéités.

## Exemple 2

Un panneau semblable à celui de l'exemple 1 est réalisé avec une teneur en plastifiant di-(éthyl-2-butyrate) de triéthylèneglycol de 20 parties en poids pour 100 parties en poids de résine. La température maximale atteinte dans l'autoclave est de 150°C. Le panneau obtenu est exempt de bulles ou d'hétérogénétés.

## Exemple 3

Un panneau est réalisé de la manière décrite dans l'exemple 1 saut que le plastifiant est de l'adipate de benzyle et d'octylo à raison de 34 parties en poids pour 100 parties en poids de résine. Le panneau obtenu n'a ni bulles ni hétérogénéités.

## Exemple 4

Sur une feuille de verre réchauffée on colle, par pressage sous les rouleaux d'une calandre, une feuille de résine de polyvinylbutyral d'épaisseur 0,5 mm plastifiée à 41 parties en poids de di-(éthyl-2-butyrate) de triéthylèneglycol pour 100 parties en poids de résine. Sur ce stratifié, on dépose avec le même dispositif que dans l'exemple 1 les cellules photo-électriques en silicium interconnectées, puis on fait tomber dessus, au travers d'un tamis, un mélange de poudres de résine de polyvinylbutyral et de plastifiant di-(éthyl-2-butyrate) de triéthylèneglycol, constitué à raison de 41 parties en poids de plastifiant pour 100 parties en poids de résine, sous forme d'une couche de 3 mm d'épaisseur. Une feuille de verre est posée sur la couche de résine de polyvinylbutyral. L'ensemble est ensuite mis dans un sac souple et traité en autoclave comme dans l'exemple 1. Ainsi que pour les exemples précédents, le panneau, vu par transparence, ne présente ni bulles ni hétérogénéités.

## Exemple 5

On recouvre l'une des feuilles rigides transparentes avec une couche d'un mélange à l'état de poudre de matière thermoplastique d'enrobage et de plastifiant, puis on dépose et on enfonce les photopiles interconnectées dans cette couche jusqu'à ce que leur surface supérieure arrive en dessous du niveau de la surface supérieure de la couche. On pose alors la seconde feuille rigide transparente directement sur les photopiles sans rajouter une seconde couche de matière thermoplastique d'enrobage et de plastifiant. Sous l'action de son propre poids et d'une faible pression, la seconde feuille écrase les monticules de poudre faisant salle entre les photopiles et les étale pour former une couche d'épaisseur constante.

## Exemple 6

On peut aussi, selon la taille des cellules, procéder comme dans l'exemple 5, mais sans enfoncer au préalable les photopiles dans la couche de poudre, et en recouvrant leur surface supérieure avec une feuille de matière thermoplastique pastifiée d'enrobage sur laquelle on dispose la seconde feuille rigide et transparente.

## Exemple 7

On réalise un panneau ayant une étanchéité améliorée a partir d'un panneau réalisé suivant l'un des exemples 1 à 4. A la périphérie du panneau on recouvre d'un moule les quatre côtés et l'on injecte sous pression dans ce moule une résine de silicone connue sous la marque "RTV" de Rhône Poulenc. Dans l'exemple considéré, ce moule est en polyméthacrylate de méthyle. Après polymérisaton de la résine silicone dans le moule, le joint formé recouvre la tranche du panneau.

On envisage également l'utilisation de différents additifs dans la poudre polyvinylbutyral plastifée. De tels additifs comprennent des stabilisants, des anti-ultraviolets, des modificateurs d'adhérence, etc.

## Exemple 8

Dans cet exemple on dispose sur une première feuille de verre une feuille de polyvinylbutyral de 0,5 mm d'épaisseur plastifié avec 41 parties en poids de di-(éthyl-2-butyrate) de triéthylèneglycol pour 100 parties en poids de résine. On dispose sur cette feuille de polyvinylbutyral les photopiles. On répand entre les photopiles et sur celles-ci une couche de poudre de polyvinylbutyral plastifié comme la feuille précédénte. On dispose sur la couche de poudre une feuille de polyvinylbutyral plastifié comme la première feuille et de même épaisseur de 0,5 mm. Enfin, on dispose sur cette seconde feuille une feuille de verre. Le panneau ainsi préparé est gainé dans un sac souple et le tout porté dans un autoclave où il est traité comme il est décrit dans l'exemple 1.

Après extraction du panneau de l'autoclave et du sac, ledit panneau de photopiles solaires ne présente, par transparence, ni bulles ni hétérogénéités.

## Exemple 9

Si l'on doit utiliser des photopiles plus épaisses que les photopiles ordinaires, ou si l'on veut obtenir entre la face supérieure active des photopiles et la feuille supérieure transparente et rigide et, après traitement à l'autoclave du panneau, une couche d'épaisseur très égale de polyvinylbutyral, on opère comme suit:

Sur la première feuille rigide, transparente ou non, on dépose un film de polyvinylbutyral, puis des photopiles interconnectées d'une épaisseur de 0,8 mm. Sur chacune de celles-ci on dépose un cache susceptible d'être retiré facilement après la mise en place du polyvinylbutyral en poudre.

Le système de prélévement pneumatique des photopiles décrit dans l'exemple 1 peut être laissé en place sur celles-ci pendant l'épandage de la poudre de polyvinylbutyral si un tel système permet cet épandage et peut être retiré sans perturber la couche. Des essais ont également été faits en disposant sur la face supérieure de chaque photopile un cache constitué d'un disque d'aluminium d'environ 1,5 mm d'épaisseur, et de même surface que celle de la photopile. Chaque disque comporte une tige plus ou moins verticale d'une hauteur suffisante pour dépasser la hauteur que présentera, après sa mise en place, la couche de polyvinylbutyral au-dessus de la face supérieure des photopiles. Après mise en place de cette couche, l'ensemble des caches est retiré au moyen de leurs tiges par tout moyen convenable. Après le dépôt de la poudre entre les cellules et sur les caches et enlèvement de ces derniers, on dispose une nouvelle couche de poudre de polyvinylbutyral qui recouvre les cellules. Puis, on dispose la feuille rigide et transparente telle qu'en verre. Le panneau ainsi préparé est, comme dans l'exemple 1, introduit dans un sac souple branché sur le vide, le tout étant porté dans un autoclave pour y subir le traitement de collage à chaud et sous pression.

La présence préalable des caches permet d'éviter des surépaisseurs de poudre de polyvinylbutyral sur l'une ou l'autre des photopiles. De telles surépaisseurs risqueraient, lors du traitement à chaud et sous pression dans l'autoclave, d'amener des cassures ou félures des photopiles recouvertes d'une surépaisseur de poudre de polyvinylbutyral par rapport aux autres photopiles.

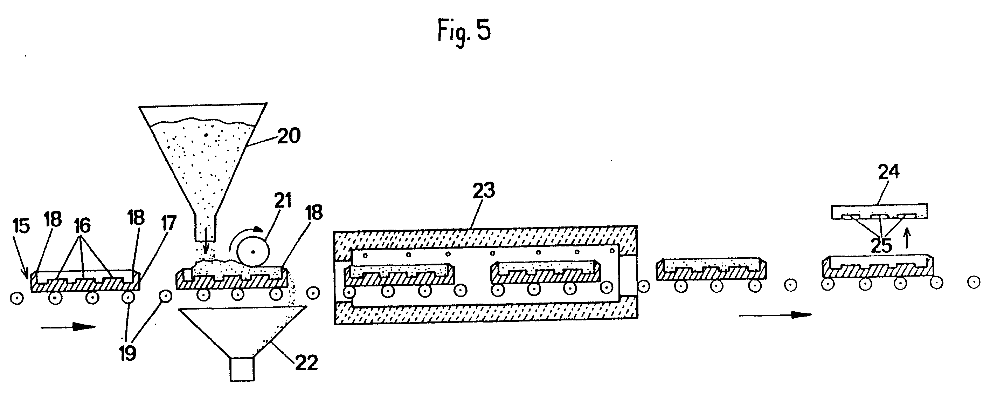

Selon l'invention on utilise, en vue d'éviter les variations d'épaisseur de la couche de poudre de résine thermoplastique, une préforme en poudre frittée. Avec référence à la fig. 5, la préforme est fabriquée au moyen d'un moule 15 en forme de cuvette plate, ouverte en haut. Le moule possède un fond plan sur lequel peuvent être fixés ou venir de fabrication, en des emplacements correspondant a ceux des photopiles dans le réseau à enrober, des éléments rigides 16 de même forme et de dimensons approximativement égales à ces des photopiles.

Les parois latérales 17 du moule sont orthogonales par rapport au fond et se terminent à leur bord supérieur par des arêtes vives 18, toutes situées dans un même plan parallèle à celui du fond. La cavité du moule est recouverte d'un revêtement anti-adhésif approprié.

Le procédé de fabrication des panneaux de photopiles au moyen de préformes selon l'invention sera décrit à propos des exemples suivants.

## Exemple 10

Le moule 15 est déposé, cavité tournée vers le haut, sur un convoyeur, tel qu'un transporteur à rouleaux 19 horizontal, qui l'achemine vers un distributeur 20 de résine thermoplastique à l'état de poudre. On utilise de la résine de polyvinylbutyral plastifiée avec de l'adipate de benzyle et d'octyle, à raison de 34 parties en poids de plastifiant pour 100 parties en poids de résine. Le moule est entraîné à une vitesse de 0,4 mètre par minute sous le distributeur qui délivre la poudre plastifiée à raison de 1000 grammes par mètre carré.

Le moule, rempli d'un excès de poudre, est ensuite dirigé par le transporteur vers un poste comportant un cylindre calandreur lisse 21, tournant autour d'un axe horizontal commandé. Le cyclindre est réglé en hauteur de manière à affleurer les arêtes vives 18 du moule, de sorte qu'à mesure que le moule défie sous le cylindre, l'excès de poudre est éliminé et la face supérieure de la préforme est rendue plane. De plus, les bords de la préforme sont nettement découpés au niveau des arêtes vives 18. La poudre en excès est recueillie dans un récipient collecteur 22.

Le transporteur introduit ensuite le moule rempli dans un four tunnel 23 chauffé à la température de 50°C. Le frittage du polyvinylbutyral plastifié est obtenu après un séjour de 10 minutes du moule dans le four.

A la sortie du four, on démoule la préforme 24 de poudre frittée dont l'une des faces comporte des empreintes 25 prêtes à recevoir les photopiles de 0,3 mm d'épaisseur, préconnectées. La hauteur de la préforme peut être égale à 5 mm environ et celle des empreintes de 1,5 mm.

On dispose ensuite sur la feuille rigide inférieure la préforme 24, empreintes tournées vers le haut, puis on introduit le réseau de photopiles interconnectées dans les empreintes. On recouvre ensuite cet assemblage avec une feuille en polyvinylbutyral plastifié dans les mêmes proportions avec de l'adipate de benzyle et d'octyle d'une épaisseur de 0,5 mm environ. L'ensemble est ensuite recouvert avec la feuille rigide supérieure et le sandwich obtenu est traité dans les mêmes conditions que dans l'exemple 1.

## Exemple 11

On reproduit le mode opératoire de l'exemple précèdent, en substituant à la feuille de polyvinylbutyral de 0,5 mm d'épaisseur une préforme de 2,5 mm d'épaisseur dont les faces ne comportent pas d'empreintes.

On obtient un panneau de photopiles exempt de bulles et d'hétérogénéités.

## Exemple 12

Comme dans l'exemple 1, on recouvre le réseau de photopiles, déposé sur une première couche de poudre de polyvinylbutyral plastifié appliquée sur le fond de la cavité du moule, par une seconde couche de poudre plastifiée dont on lisse la surface puis on introduit le moule dans le four tunnel chauffé à 50°C, la durée de séjour dans le four étant de 15 minutes. On obtient ainsi une préforme frittée de 10 mm d'épaisseur enrobant le réseau de photopiles. On achève le panneau par assemblage entre deux feuilles, la feuille supérieure étant constituée par du verre pelliculaire d'épaisseur 0,3 mm.

## Exemple 13

On procède comme dans l'exemple 10, mais en utilisant de la poudre de polyvinylbutyral non pastifié que l'on préforme et que l'on introduit pendant 15 minutes dans le four tunnel chauffé à une température de 170°C. La préforme obtenue est assemblée avec les autres éléments du panneau solaire comme dans les exemples précédents.

## Exemple 14

Dans le cas particulier où l'on utilise des photopiles de forme autre que circulaire, par exemple rectangulaire à coins arrondis ou en forme de croissant, et imbriquées de façon sensiblement jointive, on dispose le réseau de photopiles interconnectées entre une préforme plate et une préforme pourvue d'une unique empreinte périphérique, s'emboîtant autour de l'ensemble des photopiles.

## Exemple 15

On reproduit le mode opératoire de l'exemple 10 sauf que l'on utilise pour la fabrication du sandwich des plaques rigides de polymère acrylique en place de plaques de verre.

Lors d'un traitement préalable destiné à améliorer l'adhérence de la résine de polyvinylbutyral à la face de la plaque acrylique avec laquelle elle est en contact dans le sandwich, on traite ladite face, lavée en premier à l'eau additionnée de détergent, puis rincée et séchée, par une solution appliquée par pulvérisation ou ruissellement et obtenue à partir d'un mélange 50/50 en volume d'alcool éthylique et de dichloro 1,2-éthane dans lequel on dissout un adhésif acrylique assurant l'adhérence du polyvinylbutyral à la plaque acrylique, la quantité d'adhésif dissoute assurant à la solution résultante une viscosité de 1000 centipoises environ à 25°C. La face traitée est ensuite séchée pendant 30 minutes à une température ne dépassant pas 50°C.

Lors de l'assemblage du sandwich on prend soin de mettre en contact la face traitée de chacune des plaques acryliques avec la résine de polyvinylbutyral; en outre on place sur chacune des faces non traitées de ces plaques une feuille de verre trempé de 6 mm d'épaisseur on place ensuite le sandwich ainsi constitué dans la poche à vide et l'on achève la fabrication du panneau solaire comme décrit dans l'exemple 10.

Les feuilles de verre trempé, que l'on sépare aisément du panneau terminé, ont pour but de prévenir la déformation éventuelle des plaques acryliques durant le passage du sandwich en autoclave.

## Exemple 16

On reproduit l'exemple 10 en utilisant comme plaque rigide inférieure une plaque d'aluminium ou d'alliage d'aluminium de 3 millimètres d'épaisseur minimale.

La face de cette plaque en contact dans le sandwich avec la résine de polyvinylbutyral, doit subir un pré-traitement qui comprend en premier lieu un dégraissage et un séchage soignés et en second lieu une application par pulvérisaton ou ruissellement d'un enduit primaire de silicone (Y 4310 de UNION CARBIDE) que l'on sèche pendant une demi-heure à une température de 125 à 130°C.

## Revendications

1. Procédé de fabrication d'un panneau de photopiles solaires formant une batterie électrique, comprenant la formation d'un assemblage (1) par insertion entre deux feuilles rigides externes (6, 7) d'une pluralité de photopiles (12) électriquement raccordées (3) entre elles et aboutissant à des connexions électriques de sortie (4) dans un élément intercalaire central (24) comportant des évidements (25) dans lesquels peuvent se loger ladite batterie de photopiles (12) et ses raccordements électriques (3, 4) et constitué d'au moins une matière thermoplastique, au moins celle desdites feuilles rigides (6, 7) qui est disposée du côté de la face de réception des photopiles (12) étant transparente, ledit procédé comprenant en outre l'application d'un vide, à l'espace compris entre lesdites feuilles rigides (6, 7), et un échauffement de l'assemblage (1) à température suffisante pour ramollir ladite matière plastique et l'amener à coller auxdites feuilles rigides (6, 7) et à enfermer lesdites photopiles (12) et connexions (3, 4), tout en provoquant l'élimination de l'air occlus, caractérisé en ce qu'il consiste, pour préparer ledit élément intercalaire (24), à remplir d'un mélange d'une poudre de résine thermoplastique et d'un plastifiant un moule préformeur (15), le fond dudit moule présentant, pour produire lesdits évidements (25), des bossages à reliefs (16) destinés à y reproduire l'empreinte du réseau des photopiles (12, 3, 4), à aplanir la surface supérieure de la poudre, à chauffer le moule ainsi rempli à la température de frittage de la résine, à démouler ledit élément intercalaire fritté (24), la préparation de l'assemblage (1) comportant ensuite la mise en place dudit élément (24) sur l'une des feuilles rigides (6, 7) avec les évidements (25), ouverts vers le haut, l'introduction du réseau des photopiles (12) interconnectées dans les évidement (2 ) et le dépôt de la seconde des feuilles rigides (6, 7), l'échauffement subséquent, combiné à l'application d'un vide, étant conduit jusqu'à un niveau de température provoquant la fusion in situ de la résine particulaire plastifiée.

2. Procédé selon la revendication 1, caractérisé en ce qu'après avoir disposé le réseau de photopiles interconnectées (12, 3, 4) dans les évidements (25), ledit élément intercalaire fritté (24) est recouvert d'une feuille de résine thermoplastique, l'ensemble étant ensuite recouvert par la seconde feuille rigide, puis soumis à l'echauffement sous vide.

3. Procédé selon la revendication 1, caractérisé en ce qu'après avoir disposé le réseau des photopiles interconnectées (12, 3, 4) dans les évidements (25), ledit élément intercalaire fritté (24) est recouvert d'une feuille plane de résine particulaire plastifiée frittée, de structure analogue, l'ensemble étant ensuite recouvert par la seconde feuille rigide, puis soumis à l'échauffement sous vide.

4. Procédé selon la revendication 1, caractérisé en ce que le réseau de photopiles interconnectées est disposé entre un élément intercalaire fritté (24) à évidement (25) unique, et une feuille plane de résine particulaire plastifiée frittée.

## Claims

1. A method of making a panel of solar photocells forming an electric battery, comprising forming an assembly (1) by inserting between two rigid exterior sheets (6, 7) a plurality of photocells (12) electrically connected to each other (3) and terminating at electrical output connections (4) in a central intermediate element (24) comprising openings (25) in which said battery of photocells (12) and electrical connections (3, 4) is lodged and formed of at least one thermoplastics material, at least one of said rigid sheets (6, 7) which is arranged on the side of the receiving surface of the photocells being transparent, said method further comprising application of a vacuum to the space between said rigid sheets (6, 7) and heating of the assembly (1) to a temperature sufficient to soften said plastics material and cause it to adhere to said rigid sheets (6, 7) and enclose said photocells (12) and connections (3, 4) while causing elimination of occluded air, characterised in that it consists, for preparing said intermediate element (24), of filling a preform mould (15) with a mixture of a thermoplastic resin powder and a plasticiser, the bottom of said mould having, in order to produce said openings (25), relieved bosses (16) intended to reproduce the pattern of the network of photocells (12, 3, 4), levelling the upper surface of the powder, heating the filled mould to the sintering temperature of the resin, and demoulding said sintered intermediate element (24), the preparation of the assembly (1) then comprising mounting said element (24) in place on one of the rigid sheets (6, 7), with the openings (25) opening upwardly, introducing the network of interconnected photocells (12) in the openings (25) and depositing the second of the rigid sheets (6, 7), the subsequent heating combined with application of a vacuum being carried out up to a temperature causing in situ fusion of the particular plasticised resin.

2. A method according to claim 1, characterised in that after positioning of the network of interconnected photocells (12, 3, 4) in the openings (25) said sintered intermediate element (24) is covered by a sheet of thermoplastics resin, the assembly then being covered by the second rigid sheet and subjected to heating under vacuum.

3. A method according to claim 1, characterised in that after positioning of the network of interconnected photocells (12, 3, 4) in the openings (25), said sintered intermediate element (24) is covered with a flat sheet of a particular sintered plasticised resin of similar structure, the assembly then being covered by the second rigid sheet and then subjected to heating under vacuum.

4. A method according to claim 1, characterised in that the network of interconnected photocells is arranged between a sintered intermediate element (24) having a single opening (25), and a flat sheet of a particular sintered plasticised resin.

**Patentansprüche**

1. Verfahren zur Herstellung einer Platte von Solarfotoelementen, die eine elektrische Batterie bilden durch Bildung eines Aufbaus (1) aus zwei äußeren starren Folien (6, 7), zwischen denen eine Anzahl von Fotoelementen angeordnet werden, die untereinander elektrisch verbunden sind und zu elektrischen Ausgangsanschlüssen (4) in einem zentralen Zwischenelement (24) führen, welches Aussparungen (25) zur Aufnahme der Batterie aus Fotoelementen (12) und deren elektrischen Anschlüssen (3, 4) aufweist und aus mindestens einem thermoplastischen Material gebildet ist, wobei mindestens die auf der Seite der Aufnahmefläche der Fotoelemente (12) angeordnete starre Folie (6, 7) transparent ausgebildet ist und wobei nach dem Verfahren ferner Vakuum im Raum zwischen den starren Folien (6, 7) aufgebracht und der Aaufbau (1) auf eine ausreichende Temperatur erhitzt wird, um das thermoplastische Material aufzuweichen und es mit den starren Folien (6, 7) zu verkleben sowie die Fotoelemente (12) und die Anschlüsse (3, 4) unter Ausschluß von Lufteinschlüssen einzuschließen, dadurch gekennzeichnet daß zur Aufbereitung des Zwischenelementes (24) ein Gemisch aus einem Pulver aus thermoplastischem Harz und einem Plastifizierungsmittel in eine Vorform (15) gefüllt wird, deren Boden zur Bildung der Aussparungen (25) erhabene Vorsprünge (16) aufweist, welche bestimmt sind, einen Abdruck für das Netzwerk aus Fotoelementen (12, 3, 4) zu erzeugen, daß die obere Oberfläche des Pulvers geebnet, die gefüllte Form auf die Sintertemperatur des Harzes erhitzt, das gesinterte Zwischenelement (24) entformt und der Aufbau (1) dadurch hergestellt wird, daß das gesinterte Zwischenelement (24) auf eine der starren Folien (6, 7) mit nach oben weisenden Aussparungen (25) gelegt, das Netzwerk aus verbundenen Fotoelementen (12) in die Aussparungen (25) eingelegt die zweite starre Folie (6, 7) aufgelegt wird, und schließlich die Wärmebehandlung unter Vakuum bis auf ein Temperaturniveau durchgeführt Wird, welches die in situ Verschmelzung des plastifizierten teilchenförmigen Harzes bewirkt.

2. Verfahren nach Anspruch 1, dadurch gekennzeichnet, daß nach Anordnung des Netzwerkes aus verbundenen Fotozellen (12, 3, 4) in den Aussparungen (25) das gesinterte Zwischenelement (24) von einer Folie aus thermoplastischem Harz bedeckt wird und diese Anordnung dann mit der zweiten starren Folie bedeckt und schließlich der Wärmebehandlung unter Vakuum unterzogen wird.

3. Verfahren nach Anspruch 1, dadurch gekennzeichnet, daß nach Anordnung des Netzwerkes aus verbundenen Fotoelementen (12, 3, 4) in den Aussparungen (25) das gesinterte Zwischenelement (24) von einer ebenen Folie aus plastifizierten und gesinterten teilchenförmigen Harz analoger Struktur bedeckt, diese Anordnung von der zweiten starren Folie abgedeckt und schließlich einer Wärmebehandlung unter Vakuum unterzogen wird.

4. Verfahren nach Anspruch 1, dadurch gekennzeichnet, daß das Netzwerk aus verbundenen Fotoelementen zwischen einem Zwischenelement (24) mit einer einzigen Aussparung (25) und einer ebenen Folie aus plastifiziertem und gesinterten teilchenförmigen Harz angeordnet wird.

Fig.1

Fig.2

Fig.3

Fig.4

Fig. 5